# EUROPEAN PATENT SPECIFICATION

(11) **EP 0 494 088 B1**
(45) Date of publication and mention of the grant of the patent: **24.02.1999**
(21) Application number: 92104628.0
(22) Date of filing: 01.11.1986
(51) Int. Cl.: H01L 31/075, H01L 31/20

(54) **Photovoltaic device**
Fotovoltaische Vorrichtung
Dispositif photovoltaique

(30) Priority: 05.11.1985 JP 247463/85; 14.11.1985 JP 255681/85; 30.04.1986 JP 99939/86
(43) Date of publication of application: 08.07.1992
(62) Divisional of application: 86115170.2
(73) Proprietor: KANEGAFUCHI KAGAKU KOGYO KABUSHIKI KAISHA, Kita-ku Osaka-shi (JP)
(72) Inventor: Yamagishi, Hideo, Kobe-shi, Hyogo-ken (JP); Kondo, Masataka, Kobe-shi, Hyogo-ken (JP); Nishimura, Kunio, Kyoto-shi, Kyoto-fu (JP); Hiroe, Akihiko, Kobe-shi, Hyogo-ken (JP); Asaoka, Keizou, Kobe-shi, Hyogo-ken (JP); Tsuge, Kazunori, Kobe-shi, Hyogo-ken (JP); Tawada, Yoshihisa, Kobe-shi, Hyogo-ken (JP); Yamaguchi, Minori, Akashi-shi, Hyogo-ken (JP)
(74) Representative: Hrabal, Ulrich, Dr.

(56) References cited:
- EP-A- 99 720
- GB-A- 2 137 810

## Description

The present invention relates to a semiconductor device, comprising a pin-type or nip-type amorphous-containing semiconductor layer and at least two electrodes. This is a divisional application from EP-A-0221523 (86 115 170.2).

Hitherto, as a material for photoelectric converters such as solar cells, there has been used a semiconductor material comprising amorphous semiconductor such as a-Si:H, a-Si₁₋ₓ:Cₓ:H, a-Si₁₋ₓGeₓ:H, a-Si:F:H, a-Si₁₋ₓNₓH, a-Ge:H, a-Si₁₋ₓGeₓ:F:H, a-Si:H, µc-Si:H, µc-Si₁₋ₓGeₓ:H (wherein x satisfies the relationship of 0<x<1) or semiconductor material containing partially these amorphous semiconductors.

A conventional solar cell has a laminated structure of pin, nip, pinpin... or nipnip... obtained by depositing in order the same kind of amorphous semiconductors or different kinds of amorphous semiconductors having a wide energy gap only in its doping layer. The density of dopant in p-type or n-type layer is uniform throughout a direction of the thickness of the layer except the distribution of dopant due to thermal diffusion during and after the production of the device, and it is usually 0.01 to 5 at %.

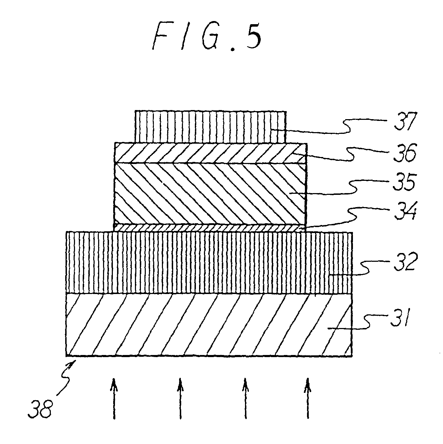

Fig. 5 shows a semiconductor device employed in a conventional solar cell using pin-type semiconductor of triple layer construction. In Fig. 5, numeral 31 is a glass substrate whereon a transparent electrode 32 is attached. On the transparent electrode 32, there are formed a p-type semiconductor layer 34, i-type semiconductor layer 35 and n-type semiconductor layer 36 in order. Further, on the n-type semiconductor layer 36, there is formed an electrode 37. The semiconductor device 38 consists of a glass substrate 31, a transparent electrode 32, a p-type semiconductor layer 34, an i-type semiconductor layer 35, a n-type semiconductor layer 36 and an electrode 37.

In the above semiconductor device 38, light enters the glass substrate 31 along the direction of arrows in Fig. 5, and is transmitted through the glass substrate 31 and the electrode 32, and then irradiates the p-type semiconductor layer 34, i-type semiconductor layer 35 and n-type semiconductor layer 36. By this irradiation, pairs of electrons and holes are generated in each semiconductor layer 34, 35 and 36. Then, electrons are collected in the n-type layer and holes are collected in the p-type layer and thereby, there are generated positive charges at the transparent electrode 32 and negative charges at the electrode 37. Thus, a photoelectric conversion is carried out to give the semiconductor device 38 a function as a photo cell.

However, a semiconductor device having the above construction has a drawback in that it cannot increase a voltage value at open-circuit condition (hereinafter referred to as Voc) during the irradiation of light, since the semiconductor device has a limitation in increasing a built-in field.

In case of using the above devices, for example, when an electromotive force more than Voc is required, a plurality of devices can be connected in series in order to remove the above drawback. Even in that case, however, the number of series connections can be decreased if Voc per one device can be improved. Further, performance of devices can be expected to be remarkably improved by making the area per one semiconductor layer large, even in case that the total area of all devices is limited.

As a result of vigorous investigation while taking notice of a device construction of a semiconductor, we inventors have discovered a semiconductor device having higher Voc and electric current (operating electric current) at a specific voltage than corventional semiconductor devices without increasing the number of series connections and total area of all devices, and have completed a semiconductor device of the present invention.

Furthermore, in the conventional semiconductor device, it is generally known that a contact resistance between a p-type semiconductor layer and an electrode at the side of a p-layer and between an n-type semiconductor layer and an electrode at the side of n-layer becomes small as a value of impurity density becomes large. It is desirable to make this contact resistance small, because it deteriorates a fill factor of a photovoltaic device when the p-type semiconductor layer and n-type semiconductor layer are used as a photovoltaic device such as a solar cell. Therefore, from this point of view, it is desirable to increase the impurity density. However, if the impurity density of the n-type and p-type semiconductor layer become too large, there is caused a problem that the characteristic as a photovoltaic device deteriorates due to the large absorption loss of light in such parts that contain impurity.

The present invention was made to solve the above problems, and an object thereof is to provide a semiconductor device having high open-circuit voltage under light irradiation, and a semiconductor device of which photoelectric conversion efficiency is improved.

The present invention provides a semiconductor device as defined in claim 1.

In the present invention, the term of "pin-type or nip-type device means a device comprising at least each one layer of (A) one conductivity type layer, (B) non-doped or slightly doped substantially intrinsic layer and (C) a conductive type opposite said conductive layer; and at least two electrodes. Further, it naturally includes a device comprising a plurarity of p, i and/or n layers; and a tandem type device wherein a unit of pin or nip is stacked.
Fig.1 is a view explaining an embodiment of a semiconductor device of the present invention;
Fig. 2 is a view explaining an embodiment of a conventional semiconductor device;
Fig. 3 is a view explaining an example of the distribution of dopant in a pin-type semiconductor layer used in the present invention and an example of the distribution of dopant in a conventional pin-type semiconductor layer;
Fig. 4 is a graph showing a V-I characteristic of solar cells obtained in Example 1 and Comparative Example 1;
Fig. 5 is a sectional view of a conventional semiconductor device.

The term "amorphous-containing semiconductor device of pin-type or nip-type" generally means such a device that has a construction used in a-Si photovoltaic devices or photodiodes. Any semiconductor device can be employed in the present invention as far as it satisfies this condition.

Further, the term "amorphous-containing semiconductor" means (1) a semiconductor composed solely of amorphous, (2) a semiconductor wherein microcrystal semiconductor is dispersed in amorphous semiconductor, or (3) a semiconductor wherein amorphous semiconductor is dispersed in large granular crystal semiconductor. These semiconductors are generally called to be non-single crystalline semiconductors.

There can be preferably employed boron-doped a-Si₁₋ₓCₓ:H as p-type amorphous-containing semiconductor layer (hereinafter referred to as p-type layer); a-Si:H, a-Si₁₋ₓGeₓ:H as i-type amorphous-containing semiconductor layer (hereinafter referred to as i-type layer); phosphorus-doped a-Si:H, µc-Si:H, or the like as n-type amorphous-containing semiconductor layer (hereinafter referred to as n-type layer), which are used in conventional amorphous semiconductor photovoltaic devices or photodiodes.

The electrical resistivity of the above semiconductors can be easily adjusted by varying a composition rate, i.e. the value of "x" or the amount of dopant in the above-mentioned formulas. In the present invention, for instance, 0.001 to 5 at % of trivalent or pentavalent elements such as P or B is used as a dopant.

As an i-type layer constituting amorphous-containing pin-type or nip-type semiconductor layers in the present invention, there can be used a layer of about 250 to 900 nm (2500 to 9000 Å) in thickness comprising, for instance, a-Si:H, a-SiGe:H, a-Ge:H, a-Si:F:H, a-SiN:H or a-SiSn:H. As a p-type layer, there can be used a layer of about 8 to 30 nm (80 to 300 Å) in thickness formed by doping, for instance, a-SiC:H, µc-Si:H or a-Si:H with elements of group IIIa of the Periodic Table which are p-type dopants. Further, as a n-type layer, there can be used a layer of about 8 to 300 nm (80 to 3000 Å) in thickness formed by doping, for instance, a-Si:H, µc-Si:H or a SiC:H with elements of group Va of the Periodic Table which are n-type dopants.

Among the above-mentioned p-type layers, layers obtained by doping a-SiC:H or a-Si:H with elements of group IIIa are preferable because they have small activation energy and small light absorption loss. Further, among the above-mentioned n-type layers, layers obtained by doping a-SiC:H, µc-Si:H or a-Si:H with elements of group Va are preferable because they have small activation energy and high conductivity.

In the foregoing explanation, there are described, as a p-type dopant, elements of group IIIa of the Periodic Table, i.e. B, Aℓ, Ga, In and Tℓ; and, as an n-type dopant, elements of group Va of the Periodic Table, i.e. N, P, As, Sb, Te and Po. However, dopants employable in the present invention are not limited to those decribed above, and any dopant can be used as far as it can produce p-type or n-type semiconductor by doping therewith.

In the pin-type or nip-type semiconductor layer of the present invention, there is provided, in at least one of the p-type layer and n-type layer, a part wherein an amount of dopant in the p-type layer cr n-type layer is lowest at a junction interface of p/i or n/i and increases gradually toward a junction interface of p/electrode or n/electrode and wherein the amount of dopant in the portion of the p-type or n-type a-SiC:H layer of at least 2 nm thickness from the junction interface of p/i or n/i is not more than 0.001 at. %.

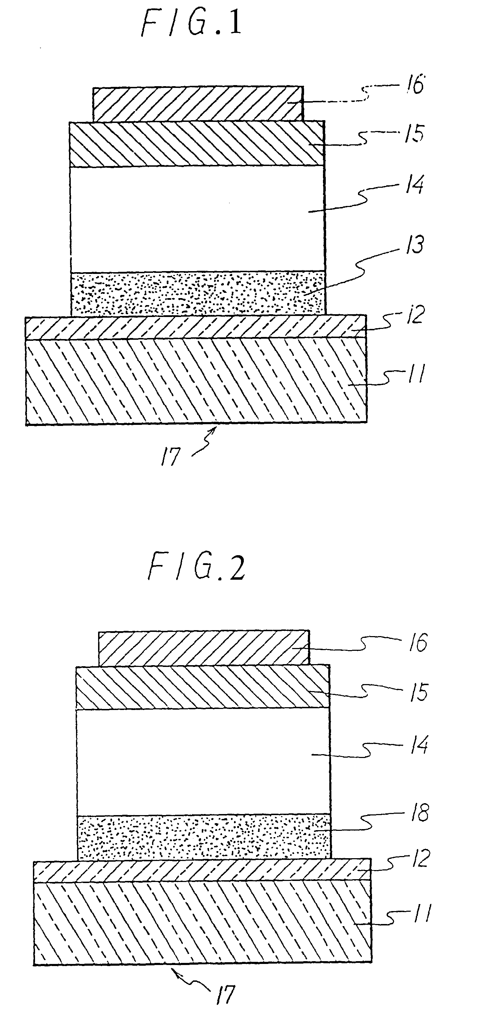

Fig. 1 is a view explaining an embodiment of a semiconductor device of the present invention. In Fig. 1, on a glass substrate 11 having a transparent electrode 12 there is provided a p-type semiconductor layer 13 in such a manner that an amount of dopant is least at a junction interface of p/i. On the p-type semiconductor layer 13, an i-type semiconductor layer 14, an n-type semiconductor layer 15 and a rear electrode 16 are formed in order.

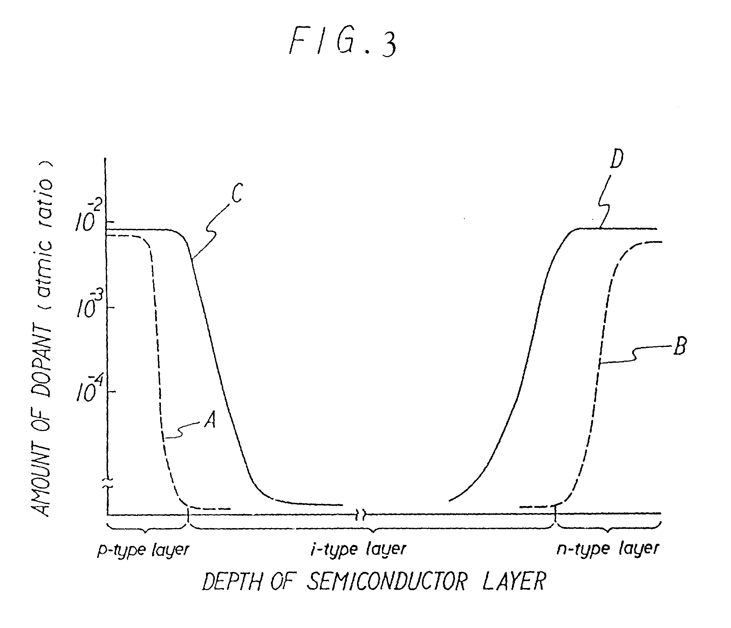

In the semiconductor device of Fig. 1, an amount of dopant is least at a junction interface of p/i. However, the semiconductor device can be produced in such a manner that the distribution of dopant in the p-type semiconductor layer is uniform and an amount of dopant is least at a junction interface of n/i in the n-type semiconductor layer. The semiconductor device can further be produced in such a manner that an amount of dopant in both p-type and n-type semiconductor layers is least at junction interfaces of p/i and n/i respectively. In Fig. 1, light 17 enters from the p-type layer side, but it might enter from the n-type layer side. The number of pin-layer is not limited to one, but it might be stacked to 2 to 5 layers. In that case, layers on the first pin-layer might also be made in such a manner that an amount of dopant is least at a junction interface of i-layer, or might be made of usual pin-layers shown in Fig. 2. Numeral 18 in Fig. 2 is a usual p-type layer.

An amount of dopant used in the p-type or n-type layer is usually 0.01 to 5 at %, but in the present invention an amount of dopant in the neighborhood of a junction interface of p/i or n/i at which an amount of dopant is least, preferably in the portion of 2 to 3 nm (20 to 30 Å) from the junction interface, more pr ferably in the portion of 100 Å from the junction interface is preferably not more than 0.001 at %. These facts are made clear from a result of trial manufactures of semiconductor device by inventors.

The distribution of dopant is required to increase gradually from the junction interface of p/i or n/i to the junction interface of p/electrode or n/electrode. By way of this constitution, the diffusion of dopant into the i-layer is reduced and the interface between the i-layer and dopant-layer is improved, and accordingly the open-circuit voltage is increased.

In the present specification, the expression of "gradual increase" does not mean a natural increase of dopants caused by the thermal diffusion, but mean successive or stairs-like increase obtained by adjusting an amount of dopant. In that case, from a viewpoint of increasing Voc, it is preferable that components other than dopant in the p-type or n-type layer do not substantially change.

Fig. 3 is a view explaining an embodiment of the distribution of dopant in a semiconductor device of the present invention wherein p-type, i-type and n-type layers comprise a-SiC:H, a-Si:H and a-Si:H, respectively. In Fig. 3, A is a graph showing a distribution of p-type dopant in a p-type semiconductor layer, B is a graph showing a distribution of n-type dopant in an n-type semiconductor layer, and C and D are graphs showing distributions of p-type dopant and n-type dopant in a conventional semiconductor device.

Fig. 3 only shows a preferable example of the distribution of dopant in the p-type or n-type layer, and the condition of distribution is not limited to that shown in Fig. 3. In other words, it is only required that the dopant content of at least one conductivity layer is minimized at a junction interface of p/i or n/i.

In case of producing a semiconductor device of the present invention using a-SiC:H as a doped layer, an insulating layer of a-SiC:H which is not doped exists at a junction interface of p/i or n/i. But, in the present invention, such a construction is employable.

Electrodes used in the present invention are not particularly limited, but there can be employed a transparent electrode, metal electrode, silicide electrode, or a laminated electrode obtained from these materials, which are usually used in producing solar cells.

As an apparatus of producing a semiconductor in the present invention, there can be employed a parallel-plate capacitively-coupled type plasma CVD apparatus, an inductively-coupled type plasma CVD apparatus, thermal CVD apparatus, ECR plasma CVD apparatus, photo CVD appartus, excited species CVD appartus, and the like. But employable apparatuses are not limited to these ones. A method of producing a semiconductor in the present invention and material used therein are not particularly limited.

A pin construction or nip construction in the present invention is one generally used in photovoltaic devices or photodiodes comprising amorphous semiconductor.

Now there are explained Example 1 and comparative Example 1 of the present invention.

### Example 1 and Comparative Example 1

A solar cell having a construction shown in Fig. 1 was made as an experiment.

SnO₂ of 80 nm (800 Å) in thickness, as a transparent electrode, was deposited on a glass to obtain a substrate.

p-type a-SiC:H film of 15 nm (150Å) in thickness was accumulated on the substrate by means of plasma CVD method. Using SiH₄, CH₄ and B₂H₆ (diluted to 1000 ppm with hydrogen) as material gas for p-type a-SiC:H, 7nm (70 Å) of SiH₄, CH₄ and B₂H₆ at 10 sccm, 30 sccm and 200 sccm respectively. Then, continuing glow discharge, residuary 8 nm (80 Å) of a-SiC:H was accumulated while gradually decreasing an amount of B₂H₆. The flow rate of B₂H₆ when the deposition of p-layer was completed was 0 sccm. i-type a-Si:H layer of 700 nm (7000 Å) in thickness was deposited by means of glow discharge decomposition. Then, n-type µc-Si:H layer of 30 nm (300 Å) in thickness was deposited by means of glow discharge decomposition, using a mixed gas of 20 sccm of SiH₄ and 100 sccm of 1000 ppm PH₃ diluted with H₂. Aℓ of 100 nm (1000 Å) in thickness was vacuum evaporated thereon as a rear metal electrode to make 1 cm² device.

The amount of dopant in the p-type layer when flowing a constant volume of B₂H₆ was 2 at %.

For comparison's sake, solar cells of conventional type were made by the same manner as described above, except that p-type a-SiC:H of 15 nm (150 Å) in thickness was deposited under the above constant flow rate.

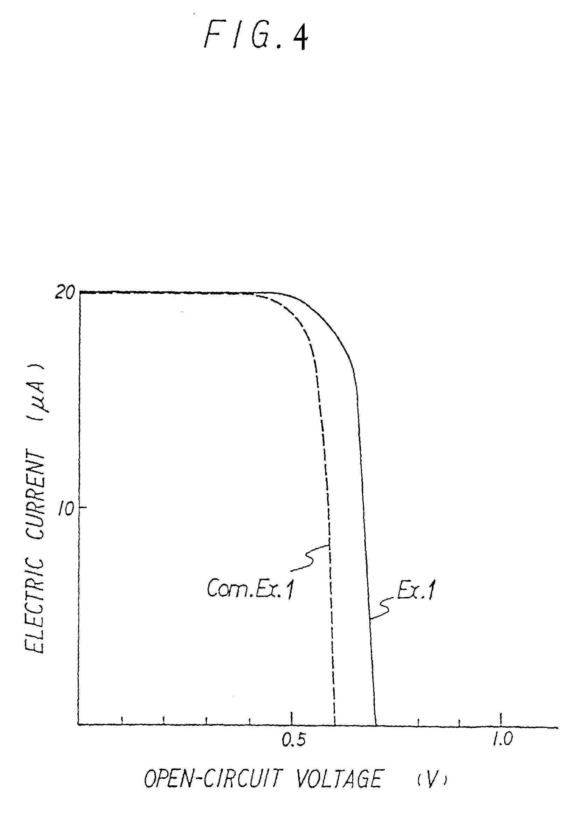

V-I characteristic of the obtained two kinds of solar cells was measured under fluorescent at a illuminance of 200 lux. The results are shown in Fig. 4.

The open-circuit voltage of the solar cell of Comparative Example 1 was about 0.6 V. On the other hand, that of the solar cell of Example 1 was 0.70 V. It was observed that the electric current and FF (Curve Fill Factor) were improved a little.

As is described in detail hereinbefore, the semiconductor device of the present invention has larger Voc and electric current (working current) at a specific voltage than conventional devices, thereby it can preferably be used in consumer-use solar cells, particularly in such solar cells that are equipped with electrical and electric equipment used under low-illumination light source such as fluorescent lamp.

The fill factor was calculated by the following formula:$\frac{\text{Maximum output}}{\text{Short circuit current x Open-circuit voltage}} \text{x 100}$

## Claims

1. A semiconductor device comprising a pin-type or nip-type amorphous-containing semiconductor layer and at least two electrodes, wherein at least one of the p-type or n-type layers is a layer of a-SiC:H and the i-type layer is a layer of a-Si:H or a-Si₁₋ₓGeₓ:H, and the amount of dopant in the p-type or n-type a-SiC:H layer gradually increases from the junction interface of p/i or n/i towards the corresponding interface of p/electrode or n/electrode,
characterised in that
the amount of dopant in the portion of said p-type or n-type a-SiC:H layer of at least 2 nm thickness from the junction interface of p/i or n/i is not more than 0.001 at. %.

2. The device of claim 1, wherein the amount of not more than 0.001 at % is within a portion of said p-type or n-type layer of at least 10 nm thickness from the junction interface of p/i or n/i.

3. The device of claim 1 or 2, wherein the dopant in said p-type layer is an element selected from the group consisting of B, A1, Ga, In and T1.

4. The device of claim 1 or 2, wherein the dopant in said n-type layer is an element selected from the group consisting of N, P, As, Sb, Te and Po.

## Patentansprüche

1. Halbleitervorrichtung, umfassend einen amorphes Material enthaltende pin-Typ- oder nip-Typ-Halbleiterschicht und mindestens zwei Elektroden, wobei mindestens eine der p-Typ- oder n-Typ-Schicht eine Schicht aus a-Sic:H ist und die i-Typ-Schicht eine Schicht aus a-Si:H oder a-Si₁₋ₓGeₓ:H ist. und wobei die Menge des Dotierungsmittels in der p-Typ- oder n-Typ-a-SiC:H-Schicht allmählich von der Verbindungsfläche von p/i oder n/i gegen die entsprechende Verbindungsfläche von p/Elektrode oder n/Elektrode ansteigt, dadurch charakterisiert, daß die Menge an Dotierungsmittel im Bereich dieser p-Typ- oder n-Typ-a-SiC:H-Schicht von mindestens 2 nm Dicke von der Verbindungsfläche von p/i oder n/i an nicht größer ist als 0.001 at %.

2. Vorrichtung nach Anspruch 1, wobei die Menge von nicht mehr als 0.001 at % innerhalb eines Bereichs dieser p-Typ- oder n-Typ-Schicht von mindestens 10 nm Dicke von der Verbindungsfläche von p/i oder n/i an vorliegt.

3. Vorrichtung nach Anspruch 1 oder 2, wobei das Dotierungsmittel in dieser p-Typ-Schicht ein Element ist. das ausgewählt wird aus der B, Al, Ga, In und Tl bestehenden Gruppe.

4. Vorrichtung nach Anspruch 1 oder 2, wobei das Dotierungsmittel in dieser n-Typ-Schicht ein Element ist. das aus der aus N, P, As, Sb, Te und Po bestehenden Gruppe ausgewählt wird.

## Revendications

1. Dispositif à semi-conducteurs comprenant une couche semi-conductrice contenant des semi-conducteurs amorphes de type pin ou de type nip et au moins deux électrodes, dans lequel au moins l'une des couches de type p ou de type n est une couche de a-SiC:H et la couche de type i est une couche de a-Si:H ou de a-Si₁₋ ₓGeₓ:H et la quantité de dopant dans la couche de a-SiC:H de type p ou de type n augmente progressivement depuis l'interface de jonction p/i ou n/i vers l'interface correspondante p/électrode ou n/électrode,
caractérisé en ce que la quantité de dopant dans la partie de ladite couche de a-SiC:H de type p ou de type n d'au moins 2 nm d'épaisseur depuis l'interface de jonction p/i ou n/i ne dépasse pas 0,001 % d'atomes.

2. Dispositif selon la revendication 1, dans lequel la quantité ne dépassant pas 0,001 % d'atomes se situe dans une partie de ladite couche de type p ou de type n d'au moins 10 nm d'épaisseur depuis l'interface de jonction p/i ou n/i.

3. Dispositif selon la revendication 1 ou 2, dans lequel le dopant dans ladite couche de type p est un élément sélectionné parmi le groupe consistant en B, Al, Ga, In et Tl.

4. Dispositif selon la revendication 1 ou 2, dans lequel le dopant dans ladite couche de type n est un élément sélectionné parmi le groupe consistant en N, P, As, Sb, Te et Po.
